# EUROPEAN PATENT SPECIFICATION

(11) **EP 3 251 157 B1**
(45) Date of publication and mention of the grant of the patent: **02.06.2021**
(21) Application number: 16707197.6
(22) Date of filing: 19.01.2016
(51) Int. Cl.: H01L 51/48

(54) **METHOD FOR FABRICATING A PHOTOVOLTAIC DEVICE**
VERFAHREN ZUR HERSTELLUNG EINES PHOTOVOLTAISCHEN VORRICHTUNG
PROCÉDÉ DE FABRICATION D'UN DISPOSITIF PHOTOVOLTAIQUE

(30) Priority: 27.01.2015 US 201562108430 P
(43) Date of publication of application: 06.12.2017
(73) Proprietor: King Abdullah University of Science and Technology, Thuwal 23955-6900 (SA)
(72) Inventor: EITA, Mohamed, Thuwal 23955-6900 (SA); EL LABBAN, Abdulrahman, Thuwal 23955-6900 (SA); USMAN, Anwar, Thuwal 23955-6900 (SA); BEAUJUGE, Pierre, Thuwal 23955-6900 (SA); ABDELSABOOR, Omar, F. M., Thuwal 23955-6900 (SA)
(74) Representative: Ipsilon
(86) International application number: PCT/IB2016/000092
(87) International publication number: WO 2016/120721

(56) References cited:
- WO-A1-2012/036337
- YONG JOO KIM ET AL: "Effect of Layer-by-Layer Assembled SnO 2 Interfacial Layers in Photovoltaic Properties of Dye-Sensitized Solar Cells", LANGMUIR, vol. 28, no. 28, 21 June 2012 (2012-06-21) , pages 10620-10626, XP055273949, US ISSN: 0743-7463, DOI: 10.1021/la3015699
- B. VERCELLI ET AL: "Self-Assembled Structures of Semiconductor Nanocrystals and Polymers for Photovoltaics. (3) PbSe Nanocrystal-Polymer LBL Multilayers. Optical, Electrochemical, Photoelectrochemical, and Photoconductive Properties", CHEMISTRY OF MATERIALS, vol. 22, no. 6, 5 February 2010 (2010-02-05), pages 2001-2009, XP055274010, US ISSN: 0897-4756, DOI: 10.1021/cm903824e
- MOHAMED EITA ET AL: "A Layer-by-Layer ZnO Nanoparticle-PbS Quantum Dot Self-Assembly Platform for Ultrafast Interfacial Electron Injection", SMALL, vol. 11, no. 1, 28 August 2014 (2014-08-28), pages 112-118, XP055273818, DE ISSN: 1613-6810, DOI: 10.1002/smll.201400939
- JANG JO ET AL: "Enhanced Efficiency of Single and Tandem Organic Solar Cells Incorporating a Diketopyrrolopyrrole-Based Low-Bandgap Polymer by Utilizing Combined ZnO/Polyelectrolyte Electron-Transport Layers", ADVANCED MATERIALS, vol. 25, no. 34, 12 July 2013 (2013-07-12) , pages 4783-4788, XP055273871, DE ISSN: 0935-9648, DOI: 10.1002/adma.201301288
- JIE MIN ET AL: "A combination of Al-doped ZnO and a conjugated polyelectrolyte interlayer for small molecule solution-processed solar cells with an inverted structure", JOURNAL OF MATERIALS CHEMISTRY A: MATERIALS FOR ENERGY AND SUSTAINABILITY, vol. 1, no. 37, 22 July 2013 (2013-07-22), page 11306, XP055273878, GB ISSN: 2050-7488, DOI: 10.1039/c3ta12162c
- YI-MING CHANG ET AL: "Conjugated polyelectrolyte and zinc oxide stacked structure as an interlayer in highly efficient and stable organic photovoltaic cells", JOURNAL OF MATERIALS CHEMISTRY A: MATERIALS FOR ENERGY AND SUSTAINABILITY, vol. 1, no. 21, 27 March 2013 (2013-03-27) , page 6446, XP055273883, GB ISSN: 2050-7488, DOI: 10.1039/c3ta10537g
- MOHAMED EITA ET AL: "Thin Films of Zinc Oxide Nanoparticles and Poly(acrylic acid) Fabricated by the Layer-by-Layer Technique: a Facile Platform for Outstanding Properties", JOURNAL OF PHYSICAL CHEMISTRY C, vol. 116, no. 7, 19 January 2012 (2012-01-19), pages 4621-4627, XP055273812, US ISSN: 1932-7447, DOI: 10.1021/jp2095328
- YONG-JIN KANG ET AL: "Spray-coated ZnO electron transport layer for air-stable inverted organic solar cells", SOLAR ENERGY MATERIALS AND SOLAR CELLS, ELSEVIER SCIENCE PUBLISHERS, AMSTERDAM, NL, vol. 96, no. 1, 17 September 2011 (2011-09-17), pages 137-140, XP028106102, ISSN: 0927-0248, DOI: 10.1016/J.SOLMAT.2011.09.045 [retrieved on 2011-10-03]

## Description

### RELATED APPLICATIONS

The applicant claims priority to US priority provisional application 62/108,430 filed January 27, 2015.

### BACKGROUND

Improved optoelectronic devices, such as photovoltaic and light emitting devices are needed, as well as improved methods for making such optoelectronic devices. For example, there is a general need for lower temperature processing, more environmentally friendly, and more efficient processing methods. Solution processing is a commercially attractive process, in principle, compared to vacuum processing. Also, if possible, use of aqueous solvent systems is preferable compared to organic solvents. Moreover, processes are needed which can be used in commercially useful device structures and fabrication methods, including, for example, so-called inverted photovoltaic device structures.

One important aspect of an optoelectronic device, including a photovoltaic device, is the use in some cases of an electron transport layer (ETL), as well as the method of making the electron transport layer. So far, these ETLs are mostly prepared by sputtering which is an ultrahigh vacuum technique requiring special machinery, high voltage, and thus is neither energy nor cost-effective. On the other hand, solution processed preparation of these layers can require synthetic conditions, use of organic solvents, fume hoods, and post treatment by, for example, annealing. Thus, it presents problems as a scalable technique and has several limitations. The simpler technique spin-coating requires also special machineries and annealing as a post treatment. The materials of the ETL can include metal oxides such as, for example, TiO₂ and ZnO, which have high n type conductivity.

One example of thin layer processing is described in Eita et al., J. Phys. Chem. C, 2012, 116, 4621-4627. Here, zinc oxide nanoparticles and poly(acrylic acid) are fabricated by the layer-by-layer (LbL) technique. However, this reference does not teach or suggest use of LbL in ETL applications.

In the following supplemental background, references 1-47 are cited and listed below.

Thin-film solar cell technologies are being developed for efficient, renewable, and economically attractive large-scale energy production and to reduce greenhouse gas emissions.^{[1-4]} The development of thin-film solar cells has been based on electron-donor and electron-acceptor materials made from metal oxides,^{[5]} small-molecule chromophores,^{[6,7]} macromolecules,^{[8]} polymers^{[9,10]} and quantum dots.^{[11-13]} In donor-acceptor systems, the energy conversion efficiency is strongly dependent on the interfacial contact between the donor and the acceptor components. The architecture of a solar cell can thus provide an efficient thermodynamic driving force to dissociate a strongly bound exciton and to drive electron-transfer processes.

To produce printable, portable, and flexible bulk heterojunction (BHJ) solar cells, the development of efficient, inexpensive, and high-throughput fabrication methods is important. A number of methods to fabricate BHJ solar cells already exist, including high-vacuum deposition systems, solution processing, and direct chemical deposition on device substrates.^{[5,14-16]} Because solution processing is amenable to the formation of an interpenetrating donor-acceptor network, while also being a cost-effective approach, it is one of the most promising approaches to produce large-scale BHJ solar cell modules.^{[15,16]} Among various solution processable donor-acceptor systems, polymer BHJ solar cells based on interpenetrating networks of conjugated polymer and fullerene derivatives as donor and acceptor materials have exhibited a power conversion efficiency (PCE) up to about 10%.^{[17- 20]} This dramatic increase in photovoltaic performance is likely caused by the optimization of the morphology of the active layer, the device architecture, and the interface control of the electron donors and acceptors. The other important approach to optimizing the interpenetrating networks and interfacial contacts between the donor and acceptor components is the use of hybrid polymer-metal oxides, in which the polymer acts as the light-absorbing component.^{[15,21-24]} One of the key issues associated with the polymer-metal oxide BHJ solar cells is the high electron mobilities in the inorganic component compared with the modest hole mobilities in the polymer. Efficient polymer-metal oxide BHJ solar cells have been demonstrated using ZnO nanoparticles and a conducting polymer, such as a poly-1,4-phenylenevinylene derivative.^{[15,22]} For instance, under AM1.5 conditions, polymer/ZnO solar cells with short circuit current densities (J_{SC}) of 3.3 mA cm⁻², open circuit voltages (V_{OC}) of 0.81 V, fill factors (FF) of ca. 60%, and overall PCE of 1.6% have been reported.^{[15]} This finding indicates that ZnO, an n-type metal oxide, possessing a wide direct bandgap (3.37 eV), an appropriate conduction band, and high electron-transporting properties, is an effective electron transport layer (ETL) for inverted polymer solar cells.^{[25-27]} The strong absorption of ZnO in the UV region with a band edge cut-off at 370 nm is also important to blocking UV light and protecting the photoactive layer.^{[28]}

Though ZnO ETL for solar cells generally can be prepared by various methods, such as atomic layer deposition,^{[29]} electro deposition,^{[25]} spin-coating,^{[30]} spray-coating,^{[31]} and the sol-gel technique, ^{[26,32]} it is well known that low-temperature solution-processed amorphous ZnO layers usually yield poor device performance with a reported maximum PCE of about 3.2%.^{[31]} This indicates that low-temperature processing of ZnO may introduce substantial microstructural and/or morphological imperfections into the donor-acceptor network, which could be detrimental to many applications. Thus, ordered ZnO nanorods or crystalline ZnO films with optimized morphological and microstructural features and high carrier mobilities have been proposed to improve the performance of conducting polymer-ZnO nanoparticles (NP) BHJ solar cells.^{[22,25,31-33]} Recently, solution-processed amorphous ZnO interlayers prepared at low temperatures (100 °C) in inverted BHJ solar cells have been demonstrated to have a power conversion efficiency of about 4.1%, as efficient as solar cells based on polycrystalline ZnO films prepared at substantially higher temperatures (150-400 °C).^{[34]} On the other hand, room-temperature fabrication of ZnO ETL by spin-coating perovskite solar cells has also been reported, indicating that even annealing was not required.^{[35]} The marked efficiency of ZnO ETL fabricated at room temperature is due most probably to its crystal structure, which differs from the crystal structures fabricated by annealing.^{[31]} These findings possibly suggest that low-temperature, facile solution processing approaches are possible in the fabrication of BHJ solar cells on flexible plastic substrates. Under such processing conditions, however, the interfacial contacts between the donor and the acceptor units, which are needed to optimize the conversion efficiency, cannot be controlled. It is unknown whether good efficiencies can be obtained.

The article "Effect of Layer-by-Layer Assembled SnO2 Interfacial Layers in Photovoltaic Properties of Dye-Sensitive Solar Cells" by Yong Joo Kim et al., (Langmuir, 2012, vol. 28, n°28, p. 10629-10626) discloses a dye-sensitized solar cell comprising electrodes and an electron transport layer comprising an alternance of negatively charged 2.5 nm sized SnO₂ nanoparticles (NPs) layers and of cationic poly(allylamine hydrochloride) layers (PAH): (PAH/SnO₂)*ₙ* (n = 1-10). For the construction of such a device, a bulk TiO₂ layer is deposited over the (PAH/SnO₂)*ₙ* bilayers and subsequently calcined at 500°C to remove organic components.

The article "Self-Assembled Structures of Semiconductor Nanocrystals and Polymers for Photovoltaics (3) PbSe Nanocrystal-Polymer LBL Multilayers. Optical Electrochemical, Photoelectrochemical, and Photoconductive Properties" by B. Vercelli et al., (Chemistry of Materials, 2010, Vol. 22, n°6, p. 2001-2009) discloses self-assembled structures of semiconductor nanocrystals (NCs) and polymers for photovoltaics. In particular, the article describes mono- and multilayers from oleate-capped PbSe-NC and coordinating nonpolyconjugated polymers.

The article "A Layer-by-Layer ZnO Nanoparticle-PbS Quantum Dot Self-Assembly Platform for Ultrafast Interfacial Electron Injection" by Mohamed Eita et al. (Small, 2014, Vol. 11, n°1, p. 112-118) discloses a layer-by-layer ZnO nanoparticle-PbS quantum dot self-assembly platform for ultrafast interfacial electron injection in which the system is annealed at 300 °C for 1 hour.

The article "Enhanced Efficiency of Single and Tandem Organic Solar Cells Incorporating a Diketopyrrolopyrrole-Based Low-Bandgap Polymer by Utilizing Combined ZnO/Polyelectrolyte Electron-Transport Layers" by Jan Jo et al. (Advanced Materials, 2013, Vol. 25, n°34, p. 4783-4788) discloses bulk-heterojunction solar cells based on a diketopyrrolopyrrole-based low-bandgap polymer (PDPPTPT) and comprising a ZnO/conjugated polyelectrolyte layer as electron transfer layer in which the system is annealed at 220°C and 120°C.

The article "A Combination of Al-doped ZnO and a Conjugated Polyelectrolyte Interlayer for Small Molecule Solution-Processed Solar Cells with an Inverted Structure" by Jie Min et al. (Journal of Materials Chemistry A: Materials for Energy and Sustainability, 2013, vol. 1, n°37, p. 11306) discloses a combination of Al-doped ZnO and a conjugated polyelectrolyte interlayer for small molecule solution-processed solar cells with an inverted structure in which the system is annealed at 140°C and 120°C.

The article "Conjugated Polyelectrolyte and Zinc Oxide Stacked Structure as an Interlayer in Highly Efficient and Stable Organic Photovoltaic Cells" by Yi-Ming Chang et al. (Journal of Materials Chemistry A: Materials for Energy and Sustainability, 2013, vol. 1, n°21, p. 6446) discloses conjugated polyelectrolyte and ZnO stacked structure as an interlayer in photovoltaic cells.

WO 2012/036337 discloses an interface between the charge transfer layer that can selectively transfer the charge while lowering the electron injection barrier, the charge transfer layer consisting of a double layer of a metal oxide/dipole forming material.

The article "Spray-Coated ZnO Electron Transport Layer for Air-Stable Inverted Organic Solar Cells" by Yong-Jin Kang et al. (Solar Energy Materials and Solar Cells, Elsevier Science Publishers, 2012, 96(1), 137-140) discloses a spray-coated ZnO electron transport layer and compares the performance of the spray-coated transport layer with transport layers formed using spin-coating and sputtering, where annealing is performed in all but the sputtering implementation.

### SUMMARY

Embodiments described and/or claimed herein include methods for fabricating a photovoltaic device. A tin-doped indium oxide (ITO) layer is patterned on a substrate. An electron transport layer is prepared using layer-by-layer deposition by immersing the substrate in a poly(allylamine hydrochloride) (PAH) solution and alternately immersing the substrate in polyacrylic acid (PAA) and zinc oxide (ZnO) dispersions to form the electron transport layer. A layer of a mixture of poly(benzo[1,2-b:4,5-b']dithiophene-thieno[3,4-c]pyrrole-4,6-dione) (PBDTTPD) and [6,6]-phenyl C61 butyric acid methyl ester (PCBM) is spin-coated on the electron transport layer. A molybdenum oxide (MoO₃) layer is evaporated on the PBDTTPD/PCBM layer. Silver electrodes are evaporated on the MoO₃ layer. The electron transport layer is not annealed and the PAA and ZnO dispersions are in aqueous solutions.

The layer-by-layer deposition is carried out with use of inks.

The method can further comprise forming a quantum dot layer on the and in contact with the electron transport layer prior to spin-coating the PBDTTPD/PCBM layer. The quantum dot layer can comprise lead sulfide, PbS, quantum dots.

The substrate can be alternatively submerged in the PAA and ZnO dispersions to form 2-6 bilayers comprising PAA and ZnO.

### BRIEF DESCRIPTION OF THE FIGURES

Figures 1A-B illustrate for one embodiment (A) an architecture of an inverted bulk heterojunction solar device (B) employing ZnO layer assembled at room temperature using the LbL technique. More particularly, Figures 1A and 1B illustrate (A) the device architecture of a layer-by-layer ZnO NP/poly(benzo[1,2-b:4,5-b']dithiophene-thieno[3,4-c]pyrrole-4,6-dione) (PBDTTPD)/[6,6]-phenyl C₆₁ butyric acid methyl ester (PCBM) ordered bulk hetero-junction solar cell. (B) the layer-by-layer structure consisting of multilayers of polyacrylic acid (PAA) and ZnO nanoparticles.
Figure 2 illustrates for one embodiment an AFM height image of the prepared ZnO film before (upper) and after (lower) coating with the polymer hetero-junction.
Figure 3 illustrates for one embodiment the effect of annealing and ZnO film thickness (number of bilayers) on the resulting device efficiency.
Figure 4 illustrates for one embodiment film thickness and surface roughness as a function of number of bilayers.
Figure 5 illustrates for one embodiment the power conversion efficiency as a function of film thickness for the LbL films (layer by layer) compared to sputtered films.
Figure 6 illustrates for one embodiment the layer by layer technique to form a ZnO film onto ITO glass, a layer of PbS - as a donor - was coated on the surface of ZnO which works as acceptor.
Figure 7 illustrates for one embodiment time resolved laser spectroscopy used to investigate the electron transfer at the PbS-ZnO interface.
Figures 8a-c illustrate (a) Changes in the thickness and root mean square (RMS) roughness of the surface with increasing number of bilayers, (b) and (c) AFM height images of one bilayer and five bilayers of ZnO/PAA thin films, respectively, on silica substrates.
Figures 9a-b illustrate (a) the UV-Vis absorption spectrum of a polymer BHJ on top of a five-bilayer ZnO/PAA thin film. (b) The corresponding AFM height image of the same device showing the active polymer layer covering the surface of the ZnO nanoparticles and filling the pores in between.
Figures 10a-d illustrate inverted BHJ solar cells fabricated from the PBDTTPD derivatives, under AM1.5G illumination; cast from CB, with 5% (v/v) CN additive showing (a) solar cell PCEs of the as-prepared and annealed ETLs as a function of the number of layers, (b) PCE as a function of ETL thickness, (c) characteristic *J-V* curves and (d) external quantum efficiency (EQE) spectra of sputtered and LbL ZnO/PAA ETL-containing devices.
Figures 11a-b illustrate (a) C1s XPS spectra of a four-bilayer ZnO/PAA as-prepared and annealed thin film at 300°C in air for one hour; (b) ATR-FTIR spectra of the as-prepared and annealed ZnO/PAA films showing the band of the free carboxylate group.

### DETAILED DESCRIPTION

### INTRODUCTION

### References

US priority provisional application 62/108,430 filed January 27, 2015. Eita et. Al., Small, 2015, 11, 1, 112-118. Eita et. Al., Adv. Funct. Mat., 2015, 25, 10, 1558-1564.

### DEVICES

A wide variety of optoelectronic devices are known in the art. They can convert light into electricity, for example, or they can convert electricity into light, wherein the term light is used expansively to mean a broader range of the electromagnetic spectrum than mere visible light. The light can be, for example, visible, infrared, or ultraviolet. For example, photovoltaic devices are described in, for example, Organic Photovoltaics, Mechanisms, Materials, and Devices, (Sun and Sariciftci, Eds.), CRC, 2005. In addition, light emitting devices are described in, for example, Organic Light-Emitting Materials and Devices, (Li, Meng, Eds.), CRC, 2007. Organic types of devices can be made, wherein one or more layers including the active layer includes an organic component. In many cases, the devices will comprise one or more semiconducting materials or semiconducting layers.

In addition to classical photovoltaic devices, other kinds of photovoltaic devices are known in the art such as, for example, photodetectors and light-harvesting devices. Other types of optoelectronic and/or photovoltaic devices include, for example, semiconducting lasers, LEDs, photodiodes, phototransistors, photomultipliers, optoisolators, integrated optical circuit (IOC) elements, photoresistors, photoconductive camera tubes, and charge-coupled imaging devices.

Photovoltaic devices and solar cells, which are preferred embodiments, are known in the art. See, for example: (1) Cho et al., Sci. Rep., 4, doi: 10.1038/srep04306, 2014; (2) Tan et al., ACS Applied Materials & Interfaces 5, 4696-4701, doi: 10.1021/am303004r (2013); (3) Park et al., J. Mater. Chem., A1 6327-6334, doi: 10.1039/C3TA10637C (2013); (4) Sung et al., Sol. Energy Mater. Sol. Cells, 98, 103-109, doi: http://dx.doiorg/10.1016/j.solmat.2011.10.021 (2012); (5) Hau et al., Appl. Phys. Lett., 92, -, doi: doi: http://dx.doi.org/10.1063/1.2945281 (2008); and (6) Peiro et al., J. Mater. Chem. 16, 2088-2096 (2006).

See also, for example: (1) Repins, I. et al. 19·9%-efficient ZnO/CdS/CuInGaSe2 solar cell with 81.2% fill factor. Progress in Photovoltaics: Research and Applications 16, 235-239, doi:10.1002/pip.822 (2008); (2) Bouclé, J., et al., Simple Approach to Hybrid Polymer/Porous Metal Oxide Solar Cells from Solution-Processed ZnO Nanocrystals. The Journal of Physical Chemistry C 114, 3664-3674, doi:10.1021/jp909376f (2010); (3) Anta, J. A., et al., ZnO-Based Dye-Sensitized Solar Cells. The Journal of Physical Chemistry C 116, 11413-11425, doi:10.1021/jp3010025 (2012); (4) Beek, W. J. E., et al., Efficient Hybrid Solar Cells from Zinc Oxide Nanoparticles and a Conjugated Polymer. Advanced Materials 16, 1009-1013, doi:10.1002/adma.200306659 (2004); (5) Law, M., et al., Nanowire dye-sensitized solar cells. Nat Mater 4, 455-459, doi:http://www.nature.com/nmat/journal/v4/n6/suppinfo/nmat1387_S1.ht ml (2005); (6) Jean, J. et al. ZnO Nanowire Arrays for Enhanced Photocurrent in PbS Quantum Dot Solar Cells. Advanced Materials 25, 2790-2796, doi:10.1002/adma.201204192 (2013); (7) Wang, H., et al., PbS-Quantum-Dot-Based Heterojunction Solar Cells Utilizing ZnO Nanowires for High External Quantum Efficiency in the Near-Infrared Region. The Journal of Physical Chemistry Letters 4, 2455-2460, doi:10.1021/jz4012299 (2013); (8) Liu, D. & Kelly, T. L. Perovskite solar cells with a planar heterojunction structure prepared using room-temperature solution processing techniques. Nat Photon advance online publication, doi:10.1038/nphoton.2013.342. http://www.nature.com/nphoton/journal/vaop/ncurrent/abs/nphoton.2013. 342.html#supplementary-information (2013).

A wide variety of photovoltaic devices can be used as described herein including, for example, organic photovoltaic devices, dye-sensitized photovoltaic devices, quantum dot photovoltaic devices, hybrid photovoltaic devices, and photovoltaic devices including a bulk heterojunction (BHJ) in the active layer. For example, the active layer can comprise at least donor material, such as a conjugated polymer, and at least one acceptor material such as a fullerene derivative such as, for example, PCBM. The PCBM can be a C60 PCBM (PC₆₀BM or PC₆₁BM) or a C70 PCBM (PC₇₀BM or PC₇₁BM) as known in the art. The conjugated polymer can be, for example, a donor-acceptor polymer. The polymers can be soluble and can be derivatized to encourage solubility. Inverted photovoltaic devices can be made and used. Photovoltaic devices can be powered by natural light or artificial light.

For polymer photovoltaic devices, Yip et al., Energy Environ. Sci., DOI: 10.1039/c2ee02806a, describes solution processing of interfacial materials including descriptions for use of metal oxides such as ZnO and TiO₂.

The devices, as is known in the art, can comprise at least two electrodes including at least one cathode and at least one anode. An active layer can be between the electrodes in which the active layer is where charges, whether holes or electrons or combinations of holes and electrons, are created for current flow. One or more of interfacial layers can be used between the electrode and the active layer to facilitate charge transport and/or charge injection. Interfacial layers can also block a particular type of charge flow. Examples include electron transport layers (ETLs) and hole transport layers (HTLs).

Device substrates can be used as known in the art including rigid and flexible substrates such as glass or polymer substrates, respectively. Substrates can be cleaned and dried. Substrates can be coated with a positively or negatively charged layer, including a polymer layer, to facilitate further building up of charged layers. For example, a substrate can be coated with a positively charged polymer such as poly(allylamine hydrochloride).

Transparent conductive oxides such as ITO can be used as known in the art to provide a transparent conductive electrode.

Transparent photovoltaic devices can be made and used, for example, in building windows. Transparent donor can be used with transparent acceptor.

The use of antireflective layers can be avoided in some embodiments described herein.

### ELECTRON TRANSPORTING LAYER

In optoelectronic devices, electron transporting layers (ETLs) are known in the art. See, for example, US Patent Publications 2011/0308613 to Tseng et al; 2014/0137929 to Yun et al.; and 2013/0019937 to So et al.; See also, for example, WO 2012/168700; WO 2013/167224. The ETL can also have a hole blocking function.

The electron transporting layer can itself comprise one or more, two or more sub-layers including bi-layers.

The thickness of the ETL can be, for example, about 1 to about 250 nm, or about 5 nm to about 100 nm, or about 10 nm to about 50 nm.

ETL materials and fabrication methods are described further herein.

### LAYER-BY-LAYER DEPOSITION

Layer-by-layer (LbL) deposition is known in the art. See, for example, Eita et al., J. Phys. Chem. C, 2012, 116, 4621-4627; and Benten et al., Thin Solid Films, 517 (2009) 2016-2022. See also, Multilayer Thin Films: Sequential Assembly of Nanocomposite Materials, (Decher, Schlenoff, Eds.), Wiley-VCH: 2003. In this process, alternating, oppositely charged layers are deposited. A positive layer can be deposited, followed by deposition of a negatively charged layer, and this process can be repeated to build up bi-layers. The thickness of the layer can be controlled by controlling the number of bilayers.

The number of bi-layers can be selected so as to optimize a property such as device efficiency. For example, the number of bi-layers can be 2-6, or 3-5.

Layers can be rinsed in a liquid such as water before deposition of the next layer.

Dipping processes can be used including processes controlled by robots, software, and automation.

The layers can be porous which encourages good interfacial contact and high surface area which can facilitate good charge transfer.

### METAL OXIDES

Metal oxides are known in the art and can be semiconductors, and semiconductive layers can be prepared. The metal of the oxide can be a wide variety of metals including transition metals as long as they provide the needed function in, for example, an ETL. Metal oxides are used such as titanium dioxide or zinc oxide as these materials provide for high transparency over a broad frequency range and good electron mobility. Materials which provide good electron mobility are preferred.

The metal oxide can be in the form of a nanoparticle, or in other words, nanoparticulate metal oxides can be used. For a nanoparticle, the metal oxide can be used in conjunction with a surfactant to stabilize the solid in dispersed form in a solution. The surfactant can be a cationic or anionic surfactant. An example is a functionalized silane compound such as, for example, 3-aminopropyl triethoxysilane. The average particle size can be, for example, about 1 to about 100 nm, or about 1 nm to about 50 nm.

### POLYELECTROLYTES

Polyelectrolytes are known in the art, and they can be positively or negatively charged with the counterion to balance the charge of the polymer. The polyelectrolyte can comprise an uncharged backbone with charged side groups. For example, one can have an all carbon backbone with side groups comprising a negatively charged side group such as, for example, a carboxylic moiety, such as poly(acrylic acid) (PAA). The counterion of the polyelectrolyte is not particularly limited but can be, for example, an alkali metal such as sodium or potassium.

Another example of a polyelectrolyte is poly(allylamine hydrochloride) (PAH) which is a positively charged polyelectrolyte. PAH is positively charged and can be used, for example, as a precursor layer directly placed on ITO to achieve enough positive charge for the adsorption of the negatively charge PAA. Without PAH, PAA adsorption is weak and the whole film thickness and hence device efficiency can be dramatically reduced.

The number average molecular weight of the polyelectrolyte can be, for example, 1,000 to 100,000 g/mol, or 5,000 to 50,000 g/mol, or 10,000 to 25,000 g/mol.

### NANOCOMPOSITE

The combination of metal oxide, in nanoscale or nanoparticulate form, and polyelectrolyte can provide for a nanocomposite. See, Multilayer Thin Films: Sequential Assembly of Nanocomposite Materials, (Decher, Schlenoff, Eds.), Wiley-VCH: 2003.

### SOLVENT CARRIER

The metal oxide can be in particulate form, including nanoparticulate form, and can be dispersed in a solvent carrier or a liquid carrier. This can provide an ink. The solvent carrier is used to disperse the solid particles and can comprise one or more solvents including water and solvents miscible with water. The solvent carrier can be an aqueous based solvent carrier in which either water is the only solvent used or water is by weight percent the majority solvent present, even if mixed with one or more solvents mixed with the water.

The pH of the aqueous solution or dispersion can be controlled as needed, and can be below 7 or above 7. For example, pH can be 6 to 9. The pH of the metal oxide solution or dispersion can be less than 7 (e.g., 6-7) and the pH of polyelectrolyte solution or dispersion can be more than 7 (e.g., 7-9).

One or more salts, such as NaCl, can be added to the aqueous solution. For example, a 0.1 M NaCl solution can be added to, for example, the polyelectrolyte solution.

### QUANTUM DOT LAYER

In some embodiments, the device can also comprise an additional layer in contact with the layer prepared by the LBL method such as the electron transport layer. For example, the device can also comprise at least one quantum dot layer in contact with the layer. For example, PbS quantum dots can be used in such a layer. The materials can also be called a semiconductor nanocrystal. See, for example, US Patent Publication 2010/0265307.

The quantum dots can provide for absorption and harvesting of light all over the solar spectrum range from the visible to infrared regions.

If useful, use of the quantum dot layer can mean that highly efficient electron transfer can be measured.

### METHOD OF FABRICATING THE DEVICES

The devices described herein can be prepared by a method according to present claim 1. The present invention relates to a method for fabricating a photovoltaic device, the method comprising: patterning a tin-doped indium oxide, ITO, layer on a substrate; preparing an electron transport layer using layer-by-layer deposition by immersing the substrate in a poly(allylamine hydrochloride), PAH, solution; alternately immersing the substrate in polyacrylic acid, PAA, and zinc oxide, ZnO, dispersions to form the electron transport layer, spin-coating a layer of a mixture of poly(benzo[1 ,2-b:4,5-b']dithiophene-thieno[3,4- c]pyrrole-4,6-dione), PBDTTPD, and [6,6]-phenyl C61 butyric acid methyl ester, PCBM, on the electron transport layer; evaporating a molybdenum oxide, MoO₃, layer on the PBDTTPD/PCBM layer; and evaporating silver electrodes on the MoO₃ layer, wherein the electron transport layer is not annealed and the PAA and ZnO dispersions are in aqueous solutions. If the electron transport layer is not annealed, device properties such as device efficiency can be increased.

### DEVICE PROPERTIES

The device properties can be measured by methods known in the art. For example, for a photovoltaic device, the power conversion efficiency (PCE) can be measured along with fill factor (FF), open circuit voltage (V_{oc}), and short circuit current density (J_{sc}). The power conversion efficiency can be, for example, at least 4% or at least 5% or at least 6%. The fill factor can be, for example, at least 45%, or at least 50%, or at least 55%. The J_{sc} value can be, for example, at least 10, or at least 11, or at least 12 mA/cm². As known in the art, a series of devices can be measured and the results averaged, while also a maximum measurement is identified.

### OTHER APPLICATIONS

Other applications can be found for the inventive layers described herein, particularly those which benefit from high porosity and high interfacial contact, which include, for example, catalysis and membranes.

### WORKING EXAMPLES

Additional embodiments are provided in the following non-limiting working examples.

### Example 1.

A new polymer-ZnO solar cell device was prepared. The device was based on room-temperature solution-processed methods to prepare the ZnO thin film which acts as an ETL in the device. Preparing ZnO thin film using the new method has introduced an enhancement of the device efficiently yielding, for example, 6% which is favorable to the same device components using ZnO prepared by the sputtering technique. Moreover, the ZnO thin film is prepared at room temperature, which often is a basic requirement in flexible solar cell fabrication.

Comparative devices prepared by sputtering, rather than LbL, were prepared by standard methods including radiofrequency sputtering in high vacuum using argon plasma and ZnO targets without any temperature change.

The following Table 1 provides final values for both LbL samples and sputtered samples after light soaking (in "light soaking," one leaves the ZnO layer in white light overnight before coating the active polymer layer):

**Table 1**

| **Number of bilayers** | **J_{SC}** | **V_{OC}** | **FF** | **Avg.PCE** | **Max. PCE** |
|---|---|---|---|---|---|
| | **[mA/cm²]** | **[V]** | **[%]** | **[%]** | **[%]** |
| **LbL 4 bilayers** | **12.4** | **0.87** | **55** | **5.6** | **6.0** |

| **ZnO sputtered thickness** | J_{SC} | V_{OC} | FF | Avg. PCE | Max. PCE |
|---|---|---|---|---|---|
| **[nm]** | [mA/cm²] | [V] | [%] | [%] | [%] |
| 5 | 12.3 | 0.80 | 49 | 4.1 | 4.8 |
| 10 | 12.2 | 0.85 | 49 | 4.6 | 5.1 |
| 15 | 12.0 | 0.81 | 45 | 4.0 | 4.6 |
| 30 | 11.8 | 0.83 | 50 | 4.2 | 4.9 |

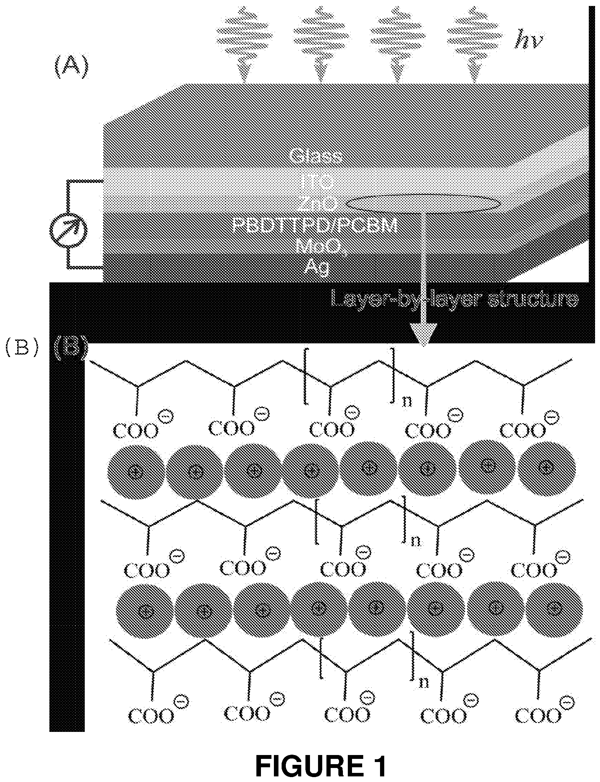

Figure 1 shows the architecture and components of the solar device. Figure 1(A) shows an inverted bulk heterojunction solar device employing ZnO layer assembled at room temperature. The layer-by-layer structure of the ZnO layer is shown in Figure 1(B).

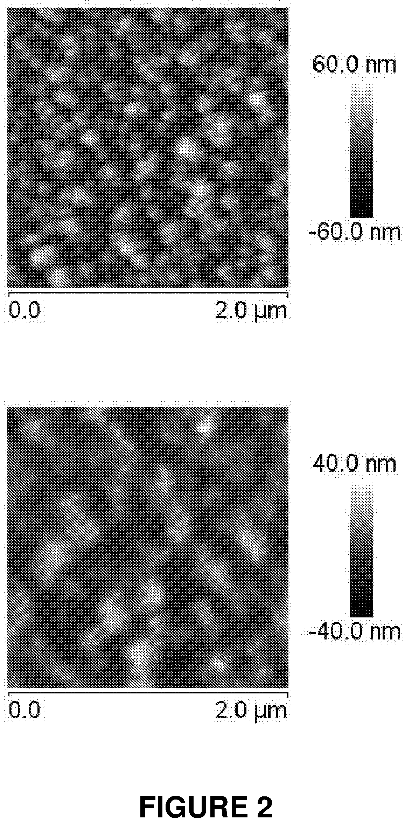

After assembly of ZnO nanoparticles on the surface, a mixture of donor (PBDTTPD) and acceptor (PC₇₁BM) was spin-coated on the surface to form a bulk hetero-junction device. Figure 2 shows the AFM height image of the prepared ZnO thin film before and after coating with the polymer hetero-junction. Figure 2 confirms the coating of the active polymer layer on the surface of ZnO nanoparticles and diffusing into its porous structure, as a sign of good and increased interfacial contact.

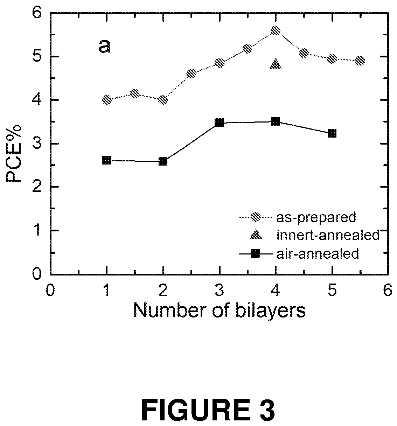

The effect of annealing and ZnO film thickness on the resulting device efficiency was investigated, Table 2 and Figure 3. The notannealed ZnO films gave higher efficiency -about double- than the ones annealed at 300°C for one hour in air. ZnO bilayers were coated with different bilayers number from 1 to 5. The device efficiency increases with increasing the film thickness (number of bilayers) until it reaches a plateau at 3 and 4 bilayers for the annealed and not annealed films, respectively. The 3 and 4 bilayers film thickness are 22 nm and 25 nm, respectively, as measured by ellipsometry. The device gives a maximum efficiency of 6% with a fill-factor (FF) of 55%, and comparably high short-circuits currents (J_{SC}) of more than 12 mA/cm². The last six rows in Table 2 are comparative examples. Z

**TABLE 2**

| **Polymer ID** | **Structure** | **Number of Bilayers** | **PCE %** | **FF** | **V_{OC}** | **J_{SC}** | |
|---|---|---|---|---|---|---|---|
| EA6 | PBDTTPD (EH/C8) | 1 | 4 | 44 | 0.82 | 11.2 | |
| EA6 | PBDTTPD EH/C8) | 1.5 | 4.14 | 48 | 0.75 | 11.5 | |
| EA6 | PBDTTPD (EH/C8) | 2 | 4 | 44 | 0.76 | 11.7 | |
| EA6 | PBDTTPD (EH/C8) | 2.5 | 4.6 | 50 | 0.83 | 11.2 | |
| EA6 | PBDTTPD (EH/C8) | 3 | 4.84 | 51 | 0.85 | 11.1 | |
| EA6 | PBDTTPD (EH/C8) | 3.5 | 5.17 | 53 | 0.86 | 11.4 | |
| EA6 | PBDTTPD (EH/C8) | 4 | 5.33 | 55 | 0.87 | 11.1 | |
| EA6 | PBDTTPD (EH/C8) | 4.5 | 5.07 | 55 | 0.85 | 10.9 | |
| EA6 | PBDTTPD (EH/C8) | 5 | 4.94 | 54 | 0.87 | 10.4 | |
| EA6 | PBDTTPD (EH/C8) | 5.5 | 4.9 | 53 | 0.85 | 10.9 | |
| EA6 | PBDTTPD (EH/C8) | 6 | 4.68 | 52 | 0.84 | 10.8 | |
| | | | | | | | |
| EA6 | PBDTTPD (EH/C8) | 1 | 2.6 | 38 | 0.6 | 11.5 | Annealed |
| EA6 | PBDTTPD (EH/C8) | 2 | 2.58 | 39 | 0.56 | 11.9 | Annealed |
| EA6 | PBDTTPD (EH/C8) | 3 | 3.47 | 45 | 0.63 | 12 | Annealed |
| EA6 | PBDTTPD (EH/C8) | 4 | 3.5 | 45 | 0.66 | 11.6 | Annealed |
| EA6 | PBDTTPD (EH/C8) | 5 | 3.23 | 45 | 0.65 | 11.1 | Annealed |
| EA6 | PBDTTPD (EH/C8) | 6 | 3.7 | 48 | 0.7 | 10.9 | Annealed |

Structures of the active layer are shown below. EH/C8 is ethylhexyl substitutent on the polymer PBDTTPD (Poly(benzo[1,2-b:4,5-. b']dithiophene-alt-thieno[3,4-c]pyrrole-4,6-dione (PBDTTPD).

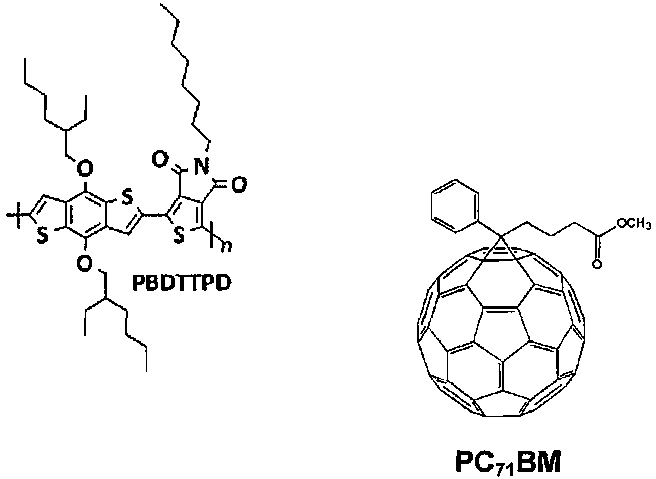

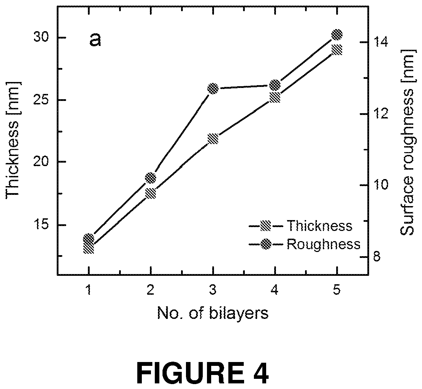

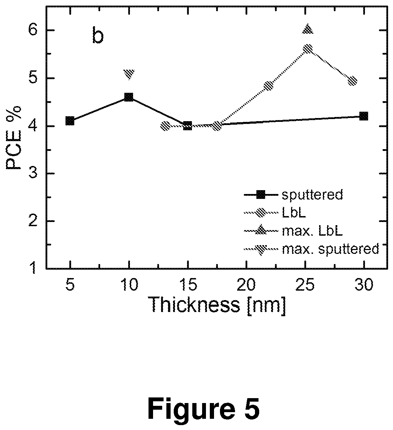

Figures 4 and 5 provide additional data for the novel devices. Figure 4 demonstrates how thickness and surface roughness increased with the number of layers. Figure 5 shows how higher efficiency can be found with use of the LbL method compared to sputtering.

### Example 2

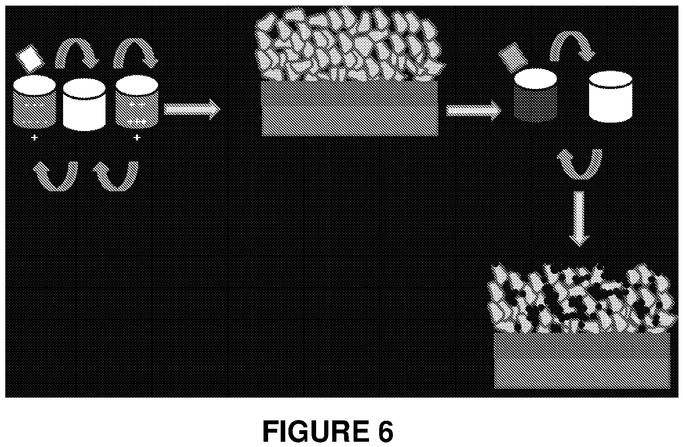

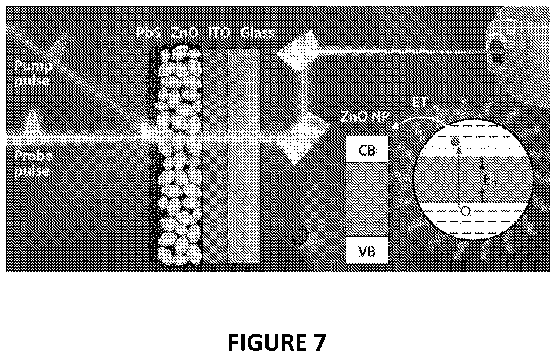

In another example, the zinc oxide layer-by-layer (LbL) approach was used in conjunction with a lead sulfide (PbS) layer. See Figures 6 and 7. See also Eita et. Al., Small, 2015, 11, 1, 112-118 for additional description.

The ZnO used here was dispersed in cationic surfactant; the PAA is of low molecular weight 15,000 g/mol; the pH of the solutions is kept at the native value at 6.7 and 8.3 for ZnO and PAA, respectively. A 0.1 M NaCl was added to the PAA solution. Cleaning the ITO substrates was done by successive sonication in 0.1 M NaOH, 2-propanol and finally acetone, and then substrates were dried with N₂ gas. Substrates were immersed in a solution of poly-allylamine hydrochloride (PAH) to coat a positively charged layer on the ITO glass first. A standard LbL method was applied; substrates were immersed in PAA and ZnO for 10 minutes each, having three rinsing steps in ultrapure water for 2 minutes each. Different thicknesses were obtained depending on the number of layers.

Lead sulfide (PbS) quantum dots (QDs) is a known donor in solar cells research. Hence, PbS was coated on top of ZnO in order to investigate the efficiency of the ZnO film to accommodate PbS and to act as an acceptor in solar cells. See Figure 6. Coating of PbS QDs was achieved by dipping the ZnO-coated substrates in the PbS QDs dispersion in hexane, withdrawing and letting to dry in the fume hood for seconds, then dipping in ethandithiol (EDT) - as a cross-linker to bind the QDs with each other to produce a uniform film - withdrawn, and letting to dry for seconds.

The ZnO-PbS films were characterized by ellipsometry, atomic force microscopy (AFM) and scanning electron microscopy (SEM) to get a full picture about the film thickness, morphology, roughness and the interfacial contact. It was found that the films have porous structure that is growing with increasing the film thickness. Due to the porous structure, the interfacial contact between ZnO and PbS is maximized so that PbS QDs are adsorbed everywhere onto the ZnO. The electron transfer dynamics, and hence the efficiency of the film to act as an acceptor layer, was investigated by ultrafast time-resolved laser spectroscopy. See Figure 7.

Electron transfer from the highest energy levels of PbS to the conduction band of ZnO without relaxation was monitored by means of transient absorption spectroscopy. This effect means that the PbS as electron absorber could harvest light all over the visible or the solar spectrum and transfer all these excited electrons to ZnO at the same time giving rise to an estimated higher solar cell efficiency. The electron transfer is supported by the higher interfacial contact between PbS and ZnO.

### SUPPLEMENTAL DESCRIPTION AND EMBODIMENTS:

As described above, and as further described below, the use of metal oxide interlayers in polymer solar cells has many advantages because metal oxides are abundant, thermally stable, and can be used in flexible devices. Here, a layer-by-layer (LbL) protocol is described as a facile, room-temperature, solution-processed method to prepare electron transport layers from commercial ZnO nanoparticles and polyacrylic acid (PAA) with a controlled and tunable porous structure, which provides large interfacial contacts with the active layer. Applying this LbL approach to bulk heterojunction polymer solar cells with an improved ZnO layer thickness of ca. 25 nm yields solar cell power-conversion efficiencies (PCEs) of ca. 6%, exceeding the efficiency of amorphous ZnO interlayers formed by conventional sputtering methods. Interestingly, annealing the ZnO/PAA interlayers in nitrogen and air environments in the range of 100-300°C reduces the device PCEs by almost 20 to 50%, indicating the importance of conformational changes inherent to the PAA polymer in the LbL-deposited films to solar cell performance. This protocol suggests a new fabrication method for solution-processed polymer solar cell devices that does not require post-processing thermal annealing treatments and that is applicable to flexible devices printed on plastic substrates.

An alternative technique that can be used to control the interfacial contacts is the room-temperature layer-by-layer (LbL) method. Using this method, as described above, the inventors created porous structures within the ZnO NP layers on which quantum dots, for example, could be incorporated as the light absorber layer.^{[36]}

Here, the assembly and performance of a ZnO NPs/poly(benzo[1,2-b:4,5-b']dithiophene-thieno[3,4-c]pyrrole-4,6-dione) (PBDTTPD)/[6,6]-phenyl C₆₁ butyric acid methyl ester (PCBM) BHJ solar cell is described with the device architecture shown in Figure 1A. The inventors prepared the ZnO-based ETL by using a LbL approach based on a ZnO/polyacrylic acid (PAA) multilayered structure deposited from aqueous solutions (Figure 1B). This approach allowed the ZnO/PAA thickness and the porous structure to be tuneable.^{[36]} The inventors examined the film build-up and surface morphology of the ZnO ETL by ellipsometry and atomic force microscopy (AFM). The inventors made the polymer-fullerene BHJ device by spin-coating an active layer of PBDTTPD and PCBM onto the LbL-deposited ZnO/PAA thin film. PBDTTPDs are among the best-performing polymer donors for BHJ solar cells with PCBM acceptors, yielding high V_{OC} >0.9 V, high FFs of ca. 70%, and PCEs >6% in direct device configurations.^{[37-43]} The inventors used PBDTTPD-based BHJ solar cells as a model system to show that the performance of inverted BHJ devices with ZnO-based interlayers depends on the thickness of the ZnO layer deposited by the LbL approach. The inventors show that as-prepared LbL-deposited ZnO/PAA solar cells yield comparably high figures of merit: J_{SC} as high as 12.4 mA cm⁻², V_{OC} of 0.87 V, FF of 55%, and PCE of 6.0% at an optimized ZnO layer thickness of 25 nm. Interestingly, the performance of our as-prepared BHJ solar cells at room temperature was better than that of thermally annealed devices, indicating the importance of conformational changes of the PAA polymer in the LbL-deposited films to solar cell performance.

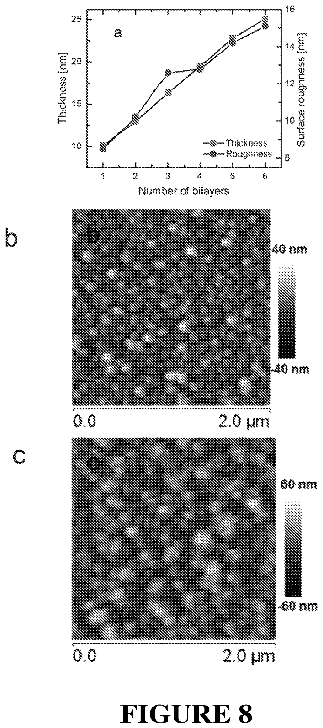

Thin films of ZnO/PAA ETL under optimized conditions were prepared according to a previously described LbL method for implementation in polymer BHJ devices.^{[36.44]} Figure 8a shows the film thickness as a function of the number of ZnO/PAA bilayers as measured by ellipsometry, demonstrating a progressive thickness variation starting at 13 nm for one bilayer and reaching 29 nm for five bilayers. AFM height images for one and five bilayer(s) are shown in Figures 8b and 8c, respectively. In the one-bilayer thin film, the ZnO NPs cover the substrate in a densely packed manner. In addition, the inventors also measured the film thickness by AFM step analysis for comparison, and found that the thicknesses of the 1 and 5 bilayer samples may be approximated to ca. 12 and 30 nm, respectively, which are comparable to those measured by ellipsometry.

The ZnO NPs are irregular in shapes with ∼20 nm in sizes as apparent in transmission electron microscopy (TEM) image. whereas the hydrodynamic radius is 99 nm as measured by dynamic light scattering (DLS) in solution.^{[44]} These results suggest that ZnO NPs are always associated with water and surfactant molecules, and hence several associated ZnO NPs co-adsorb together onto the surface as seen in the AFM image. By increasing the number of bilayers, the nanoparticles tend to assemble to form a nanoporous structure as seen in the AFM image in Figure 8c. The surface roughness as measured by AFM increases as the number of bilayers increases as shown in Figure 8a. Apparently, the surface roughness is high at a given film thickness, e.g., the five-bilayer film is 29 nm thick while its surface roughness is 14.2 nm. The overall thickness of the film is lower compared to the average particle size of ZnO NPs. This observation was reported previously and is due to imperfections in the multilayer structure.^{[44]} Adsorption happens at the beginning of the process in separate domains. The porous structure is hence formed from the beginning. By increasing the number of bilayers, the porous structure grows and thus the overall film thickness is low. Given that ZnO nanoparticles are granular and not spherical, the film build-up is not a consequence of the particle size in the Z-direction. There is a three-dimensional build-up of granules that could fit everywhere in the porous structure rather than growing only in the Z-direction giving rise to the low thickness reported by ellipsometry (Figure 8a) and by AFM. On the other hand, in such colloidal domain, smaller charged particles reach the surface easier and faster than bigger particles. It is apparent then that the overall film thickness is not necessarily correlated with the ZnO particle size.

Thin-film BHJ solar cells with an inverted configuration of ITO/ZnO/PBDTTPD: PC₇₁BM/MoO₃/Ag were fabricated with ZnO/PAA ETLs prepared by the LbL technique. Cells with optimized active layers of PBDTTPD:PC₇₁BM in a blend ratio of 1:1.5 (wt/wt) were cast from chlorobenzene (CB) with 5% (v/v) of the processing additive 1-chloronaphthalene (CN).

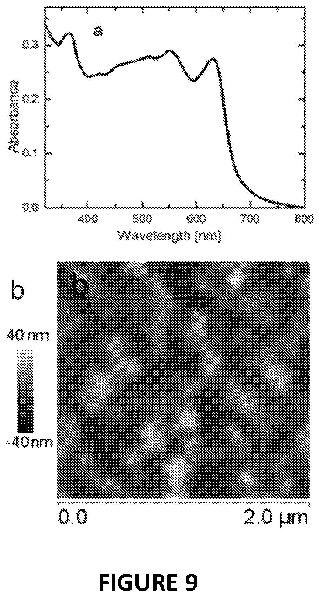

Figure 9a shows the UV-Vis absorption spectrum of the BHJ device. The spectrum shows the absorption peak of ZnO NPs at ca. 365 nm while the whole absorption range up to 700 nm indicates the absorption of the polymer-fullerene active layer. The AFM height image (Figure 9b) shows the polymer BHJ after casting the active layer. As is apparent, the active layer filled the porous structure of the ZnO film. This resulted in a decrease in RMS roughness of the surface from 14.2 to 8.2 nm of the ZnO/PAA film before and after coating with the active layer, respectively. Although the pores are mostly filled with the active layer, the decrease in surface roughness is as not dramatic as in work (described above) with PbS quantum dots (QDs) in which the surface roughness of a 61-nm thick ZnO layer decreased from 18.8 to 1.5 nm upon coating with PbS QDs.^{[36]} This smaller decrease is likely due to the fact that the polymer chains are soft and will follow the surface architecture of the rough ZnO underneath.

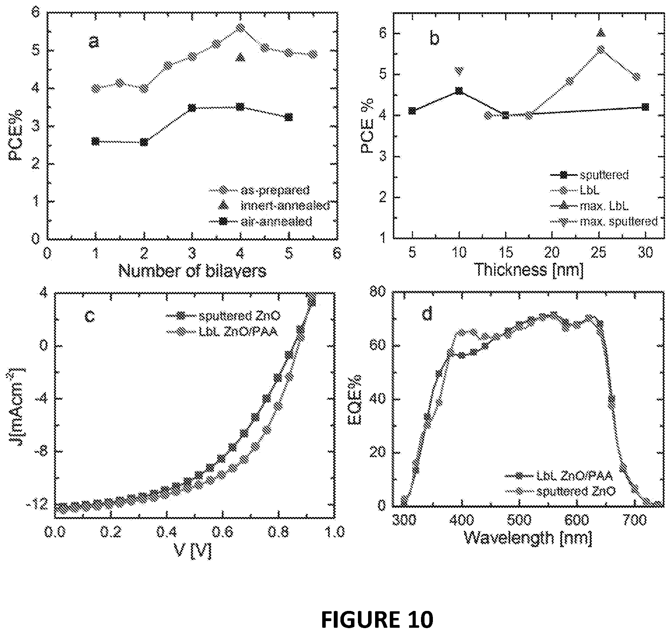

Figure 10a shows the efficiency of the as-prepared and annealed films as a function of the number of bilayers (n). The efficiency results show a strong dependence on the number of bilayers, until a plateau is reached at 4 bilayers. A further increase in the number of bilayers does not induce further efficiency improvements. Interestingly, as-prepared ETLs yield PCE values that are approximately a factor of two greater than those of thermally annealed films treated under atmospheric conditions. As shown in Table 3, as-prepared ETL solar cells achieved high PCEs of ca. 5.6% (Max.: 6%) with four bilayers of ZnO/PAA deposited by LbL with a thickness of 25 nm. These devices combined a FF of 55% and comparably high J_{SC} of more than 12 mA cm⁻². Meanwhile, solar cell devices with thermally annealed ETLs at 60, 80, 100, 200, and 300 °C (in a nitrogen atmosphere inside a glovebox) with the same number of bilayers achieved lower V_{OC}, J_{SC}, and FF than those of the as-prepared ETLs. This result indicates that annealing is not required for ETLs prepared by LbL and that in this case annealing does not help to improve device efficiency.

Figure 10b shows the efficiencies of devices using as-prepared LbL and sputtered ETLs as a function of film thickness. Sputtered ETLs have a slightly higher efficiency than LbL films at lower thicknesses, whereas LbL ETLs yield higher efficiencies at higher thicknesses. Table 4 summarizes the device results with ZnO-sputtered interlayers. In fact, the maximum performance achieved with an optimized sputtered thickness of 10 nm is PCE of ca. 4.6% (Max.: 5.1%). This lower performance compared with the LbL deposition mainly comes from a lower FF, which could arise from the difference in the interfacial contact with the active layer, considering that the surface roughness of a sputtered ZnO film is about 2 nm. The current density-voltage (*J*-*V*) curves and the external quantum efficiency (EQE) spectra of optimized LbL and sputtered ETL-deposited devices are shown in Figures 10c and 10d, respectively. The EQE response is the highest in the range of 350-650 nm, consistent with the distinct onsets of absorption of the polymers, which are within 65-70%; this observation is in agreement with the device J_{SC} values obtained (>12 mA cm⁻²). Furthermore, the EQE integration of the best device using sputtered ZnO and solution-processed LBL ZnO/PAA have values of 12.0 vs 11.8 mA/cm², respectively, which are close to the average Jsc obtained on the *J-V* curve (11.9±0.3 and 12.1±0.4 mA cm⁻², respectively). The higher PCE of the solution-processed ZnO/PAA comes essentially from the higher fill factor with respect to the sputtered ZnO (54±1 vs 46±3) and the slightly higher Voc (0.86±0.1 vs 0.84±0.1 V). This indicates that the estimated PCE of the devices are reliable. In Figure 10d, a small difference in the absorption feature between the ZnO/PAA ETLs prepared by the LbL technique and that prepared by the sputtering technique was observed in the UV region. It was considered that the spectral mismatch is due to the absorption of different amounts of ZnO nanoparticles in the ZnO ETL prepared by the two techniques.^{[36]}

Thermal annealing of ZnO ETL in air or in a glovebox resulted in lowering the solar cell efficiency as seen in Figure 10a. To understand the underlying reasons, the inventors conducted X-ray photoelectron spectroscopy (XPS) and attenuated total reflection Fourier-Transform Infrared (ATR-FTIR) experiments on the ZnO/PAA thin films before and after annealing in air. No change in the band gap of the ZnO NP was observed upon annealing. In addition, AFM height images did not exhibit a pronounced morphology or surface roughness change before and after annealing.

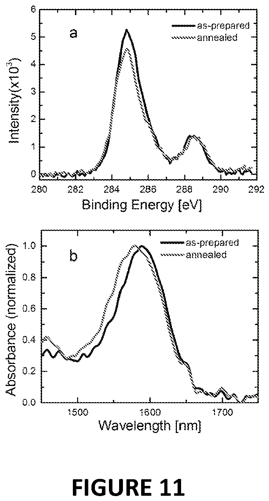

XPS C1s spectra (Figure 11a) show that the ZnO/PAA film has about 10% less overall carbon content after annealing. It should be noted that the degradation of PAA has been reported to start partially (∼7%) at 300°C.^{[45]} It is well known that steady-state infrared experiments can give insights into the local interactions between donor and acceptor moieties.^{[46]} Figure 11b shows clearly that the carboxylate group is broadened (due to charge delocalization) and downshifted by about 11 cm⁻¹ after annealing, providing a clear signature for the electrostatic binding of the free carboxylate to the surface of ZnO NPs. Here, it was inferred that before annealing, these free carboxylates with their negative charges drive the electrons to the ZnO surface by means of repulsion forces. After annealing, conformational changes take place in the polyelectrolyte chain, and some of the free carboxylates bind electrostatically to the ZnO surface as indicated in the IR data, thus decreasing the effective repulsion force to drive the electrons to the surface of the ZnO layer. In addition, because of the binding mode and the conformational changes in the polyelectrolyte chain, it can be assumed that some of the active sites on the surface of the ZnO NP are no longer available as a pathway for the electrons to percolate. Electrostatic binding of free carboxylate together with the increased oxygen defects after annealing in air could contribute to the decreased device efficiency of the corresponding devices. It is worth pointing out that the device efficiency is also lower after annealing in a nitrogen environment compared to that of the as-prepared film, but higher than that of the air-annealed film, indicating that oxygen defects created after annealing in air can be considered as a major source of trap states, resulting in the low conversion efficiency after annealing.

In conclusion, the inventors have shown that the layer-by-layer assembly of ZnO NPs and polyacrylic acid (PAA) under ambient conditions is a simple and effective approach to produce efficient inverted BHJ polymer solar cells. Following this approach, the inventors demonstrated devices with ca. 6.0% PCE, exceeding the PCE values of devices with ZnO interlayers deposited via conventional sputtering methods. Depositing ZnO interlayers by the LbL approach is advantageous over other methods because it does not require any post-processing thermal annealing step and, in turn, it is applicable to flexible devices. In addition, the use of aqueous solvents minimizes the environmental footprint of the deposition process. The LbL-deposited ZnO/PAA platform is expected to be applicable to any inverted polymer-fullerene BHJ device as well as to other solar-cell architectures.

### Experimental Section (Working Examples)

*Preparation of ZnO ETL.* The solar cells were prepared on glass substrates with tin-doped indium oxide (ITO, 15 Ω sq⁻¹) patterned on the surface. The substrates were first immersed in an ultrasonic bath of diluted Extran 300 for 15 min, then rinsed in flowing deionized water for 5 min before being sonicated for 15 min in 0.1 M NaOH solution and rinsed with ultrapure water. This was followed by sonication in successive baths of isopropanol and acetone for 15 minutes each. Finally, the substrates were dried with pressurized nitrogen. Next, 0.5 g/L solutions of polyallylamine hydrochloride (PAH) (15000 g/mol) and polyacrylic acid (PAA) (15000 g/mol, 35% as sodium salt in water) were prepared in ultrapure water with the addition of 0.1 M NaCl. The ZnO NP dispersion (stabilized by cationic surfactant 3-Aminopropyl triethoxysilane, 50 wt.% in water, size<100 nm) was diluted at a concentration of 0.1 wt. % in ultrapure water. All chemicals were purchased from Sigma-Aldrich. For the LbL coating, substrates were first immersed for 20 minutes in PAH solution in order to coat one PAH layer to facilitate adsorption of the negatively charged PAA. The LbL coating was followed by immersion of substrates for 10 minutes in PAA and ZnO dispersions and consequently with three rinsing steps in ultrapure water for 2 minutes each. Finally, the films were dried with nitrogen after completion of the immersion cycles.

*Characterization.* The size of ZnO NPs was determined from TEM imaging. Thicknesses and refractive indices of thin films were measured by a spectroscopic ellipsometer (M2000, J. A. Wollam Co. Inc.) at variable incidence angles of 55-65° with increments of 5°. The thicknesses and refractive indices were calculated by fitting the data to a Cauchy model.^{[47]} AFM images were recorded (Dimension Icon microscope, Veeco) in the tapping mode under ambient conditions. Additionally, the thicknesses of the thin films were measured by AFM step analysis. Absorption spectra were recorded by a Cary5000 spectrometer (Agilent Technologies). XPS studies were carried out in a Kratos Axis Ultra DLD spectrometer equipped with a monochromatic Al Kα X-ray source (1486.6 eV) operating at 150 W, a multi-channel plate and delay line detector under a 1.0 × 10⁻⁹ Torr vacuum. Binding energies were referenced to the C1s binding energy of adventitious carbon contamination, which was taken to be 284.8 eV. ATR-FTIR spectra were recorded on an FTIR spectrometer (Thermo iS10), reflectance cell from (HARRICK VariGATR).

*Device Fabrication.* All active layer solutions were prepared in a glovebox using PBDTTPD and PC₇₁BM purchased from SOLENNE. PBDTTPD and PC₇₁BM were dissolved in chlorobenzene (containing 5% (v/v) of 1-chloronaphthalene (CN) additive) and the solutions were stirred overnight at 110°C. Optimized devices were prepared using a PBDTTPD:PC₇₁BM in a ratio of 1:1.5 (by weight), with a concentration of 20 mg mL⁻¹. The effects of various solvents, solution concentrations, additive concentrations, and blend ratios on device performance were examined.

The active layers were spin-cast from the solutions at 90°C at an optimized speed for 45 s, using a programmable spin coater from Specialty Coating Systems (Model G3P-8), resulting in a film thickness of 100 to 120 nm. The samples were then dried at room temperature for 1 hour. Next, the samples were placed in a thermal evaporator to evaporate the 4 nm thick molybdenum oxide at 0.5 Å s⁻¹ and the 80 nm thick silver electrodes at 3 Å s⁻¹, at a pressure less than 1x10⁻⁷ Torr. Following electrode deposition, the samples underwent J-V testing.

*J-V* measurements of solar cells were performed in a glovebox with a Keithley 2400 source meter and an Oriel Sol3A Class AAA solar simulator calibrated to 1 sun, AM1.5 G, with a KG-5 silicon reference cell certified by Newport. The external quantum efficiency (EQE) measurements were performed at zero bias by illuminating the device with monochromatic light supplied from a Xenon arc lamp in combination with a dual-grating monochromator. The number of photons incident on the sample was calculated for each wavelength by using a silicon photodiode calibrated by NIST.

**Table 3. PV Performance of the PBDTTPD in inverted BHJ Devices with PC₇₁BM and LbL ZnO/PAA ETL after light soaking.**

| Annealing | J_{SC} | V_{OC} | FF | Avg. PCE | Max PCE |
|---|---|---|---|---|---|
| | [mA/cm²] | [V] | [%] | [%] | [%] |
| None | 12.1±0.4 | 0.86±0.1 | 54±1 | 5.6 | 6.0 |
| 60°C/1h | 11.2±0.3 | 0.83±0.1 | 46±3 | 4.3 | 4.7 |
| 80°C/1h | 12.0±0.2 | 0.74±0.1 | 39±3 | 3.4 | 3.6 |
| 100°C/1h | 11.6±0.3 | 0.64±0.1 | 40±4 | 3 | 3.4 |
| 200°C/1h | 11.3±0.5 | 0.77±0.1 | 49±4 | 4.3 | 4.7 |
| 300°C/1h | 11.1±0.4 | 0.81±0.1 | 53±3 | 4.8 | 5.3 |

**Table 4. PV Performance of the PBDTTPD in inverted BHJ Devices with PC₇₁BM and sputtered ZnO after light soaking.**

| ZnO sputtered thickness | J_{SC} | V_{OC} | FF | Avg. PCE | Max PCE |
|---|---|---|---|---|---|
| [nm] | [mA/cm²] | [V] | [%] | [%] | [%] |
| 5 | 11.9±0.4 | 0.78±0.1 | 44±5 | 4.1 | 4.8 |
| 10 | 11.9±0.3 | 0.84±0.1 | 46±3 | 4.6 | 5.1 |
| 15 | 11.7±0.3 | 0.82±0.1 | 42±4 | 4.0 | 4.6 |
| 20 | 11.3±0.5 | 0.82±0.1 | 46±4 | 4.2 | 4.9 |

### REFERENCES 1-47:

[1] B. O'Regan, M. Grätzel, Nature 1991, 353, 737.
[2] K. Ramanathan, M. A. Contreras, C. L. Perkins, S. Asher, F. S. Hasoon, J. Keane, D. Young, M. Romero, W. Metzger, R. Noufi, J. S. Ward, A. Duda, Prog. Photovoltaics: Res. Appl. 2003, 11, 225.
[3] K. L. Chopra, P. D. Paulson, V. Dutta, Prog. Photovoltaics: Res. Appl. 2004, 12, 69.
[4] F. Fthenakis, J. E. Mason, K. Zweibel, Energy Policy 2009, 37, 387.
[5] I. Repins, M. A. Contreras, B. Egaas, C. DeHart, J. Scharf, C. L. Perkins, B. To, R. Noufi, Prog. Photovoltaics: Res. Appl. 2008, 16, 235.
[6] A. Hagfeldt, M. Grätzel, Acc. Chem. Res. 2000, 33, 269.
[7] A. Hagfeldt, G. Boschloo, L. Sun, L. Kloo, H. Pettersson, Chem. Rev. 2010, *110*, 6595.
[8] F. Odobel, Y. Pellegrin, J. Warnan, Energy Environ. Sci. 2013, 6, 2041.
[9] H. Hoppe, N. S. Sariciftci, In Photoresponsive Polymers II; S. R. Marder, K.-S. Lee (Eds.); Springer Berlin Heidelberg: 2008; Vol. 214, p 1.
[10] G. Li, R. Zhu, Y. Yang, Nat. Photon. 2012, 6, 153.
[11] A. Kongkanand, K. Tvrdy, K. Takechi, M. Kuno, P. V. Kamat, J. Am. Chem. Soc. 2007, 130, 4007.
[12] P. V. Kamat, J. Phys. Chem. C 2008, 112, 18737.
[13] A. O. El-Ballouli, E. Alarousu, M. Bernardi, S. M. Aly, A. P. Lagrow, O. M. Bakr, O. F. Mohammed, J. Am. Chem. Soc. 2014, 136, 6952.
[14] J. Bouclé, H. J. Snaith, N. C. Greenham, J. Phys. Chem. C 2010, 114, 3664.
[15] W. J. E. Beek, M. M. Wienk, R. A. J. Janssen, Adv. Mater. 2004, 16, 1009.
[16] J. A. Anta, E. Guillén, R. Tena-Zaera, J. Phys. Chem. C 2012, 116, 11413.
[17] G. Li, V. Shrotriya, J. Huang, Y. Yao, T. Moriarty, K. Emery, Y. Yang, Nat. Mater. 2005, 4, 864.
[18] J. Y. Kim, K. Lee, N. E. Coates, D. Moses, T.-Q. Nguyen, M. Dante, A. J. Heeger, Science 2007, 317, 222.
[19] Y. Liang, Z. Xu, J. Xia, S.-T. Tsai, Y. Wu, G. Li, C. Ray, L. Yu, Adv. Mater. 2010, 22, E135.
[20] J. You, L. Dou, K. Yoshimura, T. Kato, K. Ohya, T. Moriarty, K. Emery, C.-C. Chen, J. Gao, G. Li, Y. Yang, Nat. Commun. 2013, 4, 1446.
[21] W. U. Huynh, J. J. Dittmer, A. P. Alivisatos, Science 2002, 295, 2425.
[22] A. M. Peiro, P. Ravirajan, K. Govender, D. S. Boyle, P. O'Brien, D. D. C. Bradley, J. Nelson, J. R. Durrant, J. Mater. Chem. 2006, 16, 2088.
[23] M. M. Lee, J. Teuscher, T. Miyasaka, T. N. Murakami, H. J. Snaith, Science 2012, 338, 643.
[24] M. A. Loi, J. C. Hummelen, Nat. Mater. 2013, 12, 1087.
[25] S. Schumann, R. D. Campo, B. Illy, A. C. Cruickshank, M. A. McLachlan, M. P. Ryan, D. J. Riley, D. W. McComb, T. S. Jones, J. Mater. Chem. 2011, 21, 2381.
[26] Y. Sun, J. H. Seo, C. J. Takacs, J. Seifter, A. J. Heeger, Adv. Mater. 2011, 23, 1679.
[27] H.-Y. Park, D. Lim, K.-D. Kim, S.-Y. Jang, J. Mater. Chem. A 2013, 1, 6327.
[28] Y. Gao, I. Gereige, A. E. Labban, D. Cha, T. T. Isimjan, P. M. Beaujuge, ACS Appl. Mater. Interfaces 2014, 6, 2219.
[29] H. Cheun, C. Fuentes-Hernandez, Y. Zhou, W. J. Potscavage Jr., S.-J. Kim, J. Shim, A. Dindar, B. Kippelen, J. Phys. Chem. C 2010, 114, 20713.
[30] S. K. Hau, H.-L. Yip, N. S. Baek, J. Zou, K. O'Malley, A. K.-Y. Jen, Appl. Phys. Lett. 2008, 92, 253301.
[31] Y.-J. Kang, K. Lim, S. Jung, D.-G. Kim, J.-K. Kim, C.-S. Kim, S. H. Kim, J.-W. Kang, Sol. Energy Mater. Sol. Cells 2012, 96, 137.
[32] Z. Liang, Q. Zhang, O. Wiranwetchayan, J. Xi, Z. Yang, K. Park, C. Li, G. Cao, Adv. Funct. Mater. 2012, 22, 2194.
[33] D. C. Lim, W. H. Shim, K.-D. Kim, H. O. Seo, J.-H. Lim, Y. Jeong, Y. D. Kim, K. H. Lee, Sol. Energy Mater. Sol. Cells 2011, 95, 3036.
[34] L. K. Jagadamma, M. Abdelsamie, A. E. Labban, E. Aresu, G. O. N. Ndjawa, D. H. Anjum, D. Cha, P. M. Beaujuge, A. Amassian, J. Mater. Chem. A 2014, 2, 13321.
[35] D. Liu, T. L. Kelly, Nat. Photon. 2013, 8, 133.
[36] M. Eita, A. Usman, A. O. El-Ballouli, E. Alarousu, O. M. Bakr, O. F. Mohammed, Small 2014. DOI: 10.1002/smll.201400939.
[37] C. Piliego, T. W. Holcombe, J. D. Douglas, C. H. Woo, P. M. Beaujuge, J. M. J. Fréchet, J. Am. Chem. Soc. 2010, 132, 7595.
[38] C. Cabanetos, A. E. Labban, J. A. Bartelt, J. D. Douglas, W. R. Mateker, J. M. J. Fréchet, M. D. McGehee, P. M. Beaujuge, J. Am. Chem. Soc. 2013, 135, 4656.
[39] J. A. Bartelt, J. D. Douglas, W. R. Mateker, A. E. Labban, C. J. Tassone, M. F. Toney, J. M. J. Fréchet, P. M. Beaujuge, M. D. McGehee, Adv. Energy Mater. 2014, 1301733.
[40] J. Warnan, C. Cabanetos, R. Bude, A. E. Labban, L. Li, P. M. Beaujuge, Chem. Mater. 2014, 26, 2829.
[41] J. Warnan, A. E. Labban, C. Cabanetos, E. T. Hoke, P. K. Shukla, C. Risko, J.-L. Bredas, M. D. McGehee, P. M. Beaujuge, Chem. Mater. 2014, 26, 2299*.*
[42] J. Warnan, C. Cabanetos, A. E. Labban, M. R. Hansen, C. Tassone, M. F. Toney, P. M. Beaujuge, Adv. Mater. 2014, 26, DOI: 10.1002/adma .201305344.
(43) K. R. Graham, C. Cabanetos, J. P. Jahnke, M. N. Idso, A. E. Labban, G. O. N. Ndjawa, T. Heumueller, K. Vandewal, A. Salleo, B. F. Chmelka, A. Amassian, P. M. Beaujuge, M. D. McGehee, J. Am. Chem. Soc. 2014, 136, DOI: 10.1021/ja502985g.
[44] M. Eita, L. Wägberg, M. Muhammed, J. Phys. Chem. C 2012, 116, 4621.
[45] I. C. McNeill, S. M. T. Sadeghi, Polym. Degrad. Stab. 1990, 29, 233.
[46] M. J. Tan, S. Zhong, J. Li, Z. Chen, W. Chen, ACS Appl. Mater. Interfaces 2013, 5, 4696.
[47] H. G. Tompkins, E. A. Irene, Handbook of Ellipsometry, William Andrew Publishing, 2005.

## Claims

1. A method for fabricating a photovoltaic device, the method comprising:
patterning a tin-doped indium oxide, ITO, layer on a substrate;
preparing an electron transport layer using layer-by-layer deposition by
immersing the substrate in a poly(allylamine hydrochloride), PAH, solution;
alternately immersing the substrate in polyacrylic acid, PAA, and zinc oxide, ZnO, dispersions to form the electron transport layer, spin-coating a layer of a mixture of poly(benzo[1,2-b:4,5-b']dithiophene-thieno[3,4- c]pyrrole-4,6-dione), PBDTTPD, and [6,6]-phenyl C61 butyric acid methyl ester, PCBM, on the electron transport layer;
evaporating a molybdenum oxide, MoO₃, layer on the PBDTTPD/PCBM layer; and
evaporating silver electrodes on the MoO₃ layer,
wherein the PAA and ZnO dispersions are in aqueous solutions, **characterized in that** the electron transport layer is not annealed.

2. The method of claim 1, wherein the layer-by-layer deposition is carried out with use of inks.

3. The method of claim 1, further comprising:
forming a quantum dot layer on the and in contact with the electron transport layer prior to spin-coating the PBDTTPD/PCBM layer.

4. The method of claim 3, wherein the quantum dot layer comprises lead sulfide, PbS, quantum dots.

5. The method of claim 1, wherein the substrate is alternatively submerged in the PAA and ZnO dispersions to form 2-6 bilayers comprising PAA and ZnO.

## Patentansprüche

1. Verfahren zum Herstellen einer photovoltaischen Vorrichtung, wobei das Verfahren umfasst:
Strukturieren einer Schicht aus zinndotiertem Indiumoxid (ITO) auf einem Substrat;
Herstellen einer Elektronentransportschicht unter Verwendung von Schicht-für-Schicht-Abscheidung durch
Eintauchen des Substrats in eine Lösung aus Poly(allylaminhydrochlorid) (PAH);
abwechselndes Eintauchen des Substrats in Dispersionen aus Polyacrylsäure (PAA) und Zinkoxid (ZnO), um die Elektronentransportschicht zu bilden,
Rotationsbeschichten einer Schicht aus einem Gemisch von Poly(benzo[1,2-b:4,5-b']dithiophenthieno[3,4-c]pyrrol-4,6-dion) (PBDTTPD) und [6,6]-Phenyl-C61-buttersäuremethylester (PCBM) auf der Elektronentransportschicht;
Verdampfen einer Schicht aus Molybdänoxid (MoO₃) auf der PBDTTPD/PCBM-Schicht; und
Verdampfen von Silberelektroden auf der MoO₃-Schicht,
wobei die PAA- und ZnO-Dispersionen in wässrigen Lösungen vorliegen, **dadurch gekennzeichnet, dass** die Elektronentransportschicht nicht getempert wird.

2. Verfahren nach Anspruch 1, wobei die Schicht-für-Schicht-Abscheidung unter Verwendung von Tinten durchgeführt wird.

3. Verfahren nach Anspruch 1, das ferner umfasst:
Bilden einer Quantenpunktschicht auf der Elektronentransportschicht und in Kontakt mit dieser vor dem Rotationsbeschichten der PBDTTPD/PCBM-Schicht.

4. Verfahren nach Anspruch 3, wobei die Quantenpunktschicht Quantenpunkte aus Bleisulfid (PbS) umfasst.

5. Verfahren nach Anspruch 1, wobei das Substrat abwechselnd in die PAA- und ZnO-Dispersionen eingetaucht wird, um 2 bis 6 Doppelschichten zu bilden, die PAA und ZnO umfassen.

## Revendications

1. Procédé pour fabriquer un dispositif photovoltaïque, le procédé comprenant :
la formation d'un motif d'une couche d'oxyde d'indium dopé à l'étain, ITO, sur un substrat ;
la préparation d'une couche de transport d'électrons utilisant une déposition couche par couche par immersion du substrat dans une solution de poly(chlorhydrate d'allylamine), PAH ;
en variante l'immersion du substrat dans des dispersions de poly(acide acrylique), PAA, et d'oxyde de zinc, ZnO, pour former la couche de transport d'électrons,
la déposition centrifuge d'une couche d'un mélange de poly(benzo[1,2-b:4,5-b')dithiophène-thiéno[3,4-c]pyrrole-4,6-dione), PBDTTPD, et d'ester méthylique d'acide [6,6]-phényl-C61-butyrique, PCBM, sur la couche de transport d'électrons ;
l'évaporation d'une couche d'oxyde de molybdène, MoO₃, sur la couche de PBDTTPD/PCBM ; et
l'évaporation d'électrodes en argent sur la couche de MoO₃,
dans lequel les dispersions de PAA et de ZnO sont dans des solutions aqueuses,
**caractérisé en ce que** la couche de transport d'électrons n'est pas recuite.

2. Procédé selon la revendication 1, dans lequel la déposition couche par couche est effectuée par l'utilisation d'encres.

3. Procédé selon la revendication 1, comprenant en outre la formation d'une couche de points quantiques sur et en contact avec la couche de transport d'électrons avant la déposition centrifuge de la couche de PBDTTPD/PCBM.

4. Procédé selon la revendication 3, dans lequel la couche de points quantiques comprend des points quantiques de sulfure de plomb, PbS.

5. Procédé selon la revendication 1, dans lequel le substrat est alternativement immergé dans les dispersions de PAA et de ZnO pour former 2 à 6 bicouches comprenant du PAA et du ZnO.
